Europäisches Patentamt

**European Patent Office**

Office européen des brevets

(19)

(11) Veröffentlichungsnummer : **0 014 969**
**B1**

(12) **EUROPÄISCHE PATENTSCHRIFT**

(45) Veröffentlichungstag der Patentschrift :
03.02.82

(21) Anmeldenummer : 80100764.2

(22) Anmeldetag : 14.02.80

(51) Int. Cl.³ : **H 04 B 3/28**, H 04 B 3/44,
**H 03 H 7/01**

(54) **Eingangsanordnung für empfangsseitiges Leitungsendgerät eines Nachrichtenübertragungssystems.**

(30) Priorität : 19.02.79 DE 2906244

(43) Veröffentlichungstag der Anmeldung :
03.09.80 (Patentblatt 80/18)

(45) Bekanntmachung des Hinweises auf die Patenterteilung : 03.02.82 Patentblatt 82/05

(84) Benannte Vertragsstaaten :
AT BE CH DE FR GB IT LU NL SE

(56) Entgegenhaltungen :
AT - B - 304 642
DE - A1 - 2 535 722
DE - A1 - 2 804 086
DE - B - 1 911 960
DE - B - 1 153 809

TELCOM REPORT, 1. Jahrgang, Heft 6, Dezember
1978

Siemens Aktiengesellschaft Berlin und München
(DE)

P. GOTTA, T. TREDESE, G. GEISLER und M.
MEHNER « Erste 60-MHz-Koaxialkabelstrecke in
Italien für 10 800 Ferngespräche », Seiten 399 bis
403

(73) Patentinhaber : SIEMENS AKTIENGESELLSCHAFT
Berlin und München
Postfach 22 02 61
D-8000 München 22 (DE)

(72) Erfinder : Popp, Erwin, Dipl.-Ing.
Siegfriedstrasse 11
D-8014 Neublberg (DE)
Erfinder : Appelmann, Wolfgang, Dipl.-Ing.
Ringstrasse 1
D-8000 München 70 (DE)
Erfinder : Möhrmann, Karl Heinz, Dipl.-Ing.
Kemptener Strasse 65
D-8000 München 71 (DE)

Imprimerie Jouve, 18, rue St-Denis, 75001 Paris, France

## Eingangsanordnung für empfangsseitiges Leitungsendgerät eines Nachrichtenübertragungssystems

Die Erfindung bezieht sich auf eine Eingangsanordnung für ein empfangsseitiges Leitungsendgerät eines Nachrichtenübertragungssystems mit Gleichstrom-Fernspeisung über die Innenleiter von Koaxialpaaren, die zusammen mit symmetrischen Leitungen in einem Kabel mit gemeinsamem Kabelaußenleiter zusammengefaßt sind, mit einer Eingangsweiche im Leitungsendgerät, das über eine triaxiale Schnittstelle an eine triaxiale Leitung, die aus einem der Koaxialpaare und einem mit dem Kabelaußenleiter verbundenen Schirm besteht, angeschaltet ist.

Breitbandige analoge und digitale Koaxialkabelsysteme werden in Europa allgemein auf dem in seinen Eigenschaften vom CCITT (Comité Consultatif International Télégraphique et Téléphonique) festgelegten Koaxialpaar 2,6/9,5 mm betrieben. Mehrere Koaxialpaare werden mit symmetrischen Leitungen zu einem Kabel zusammengefaßt. Das übliche Koaxial-Fernkabel Form 32c enthält 12 Koaxialpaare 2,6/9,5 mm und eine große Anzahl von symmetrischen Leitungen, den sogenannten Beipack. Die symmetrischen Leitungen werden für alle möglichen Betriebs- und Überwachungszwecke, wie Druckgasüberwachung oder Dienstleitungen verwendet. Sie können auch unsymmetrisch betrieben werden.

Die Innenleiter der Koaxialpaare werden im folgenden mit « a », die Außenleiter mit « b » und der allen Koaxialpaaren und dem Beipack gemeinsame geerdete Schirm mit « ç » bezeichnet.

Nach DIN 47 250, Teil 1, werden Kabel mit einem Innenleiter und einem konzentrischen Außenleiter, die zusammen ein herkömmliches Koaxialkabel bilden, dann als triaxiale Leitung bezeichnet, wenn ein zweiter konzentrischer Außenleiter als Abschirmung hinzukommt. Die Verbindungsstellen dieser Kabel werden folglich als triaxiale Schnittstellen bezeichnet.

Weitverkehrssysteme enthalten, wenn sie analog arbeiten, in regelmäßigen Abständen Zwischenverstärker und wenn sie digital arbeiten, Regeneratoren. Eine jeweils größere Anzahl von Verstärkern bzw. Regeneratoren wird von den oberirdischen Endstellen her durch Fernspeisung über die Innenleiter der Koaxialpaare mit Energie versorgt. Üblicherweise ist eine Gleichstrom-Reihenspeisung vorgesehen. Bei Parallellaufen des Kabels zu elektrifizierten Bahnlinien oder Hochspannungsleitungen ist mit nicht unbeträchtlichen niederfrequenten Störströmen zu rechnen, die sich dem Speisegleichstrom überlagern. Diese Dauerbeeinflussung läßt sich auf ein erträgliches Maß durch Betrieb der Anlage mit Schwebepotential reduzieren, d.h. die Außenleiter b der Koaxialkabel sind gegen den geerdeten Schirm « c » isoliert.

Bei dieser Betriebsart ist es zur Potentialtrennung notwendig, im sende- und empfangsseitigen Leitungsendgerät hochspannungsfeste Trennstellen zwischen dem Innenleiter a, dem Außenleiter b und dem Schirm c zu haben. Insbesondere bei Systemen mit einer sehr hohen Bandbreite von beispielsweise einigen 100 MHz ist die Realisierung hochspannungsfester Übertrager mit dieser Bandbreite extrem schwierig. Hier werden daher Hochspannungskondensatoren als Trennelemente benutzt.

Ein derartiges Leitungsendgerät ist im älteren Vorschlag (DE-A1-28 04 086) beschrieben.

Wenn zwischen dem Außenleiter b eines Koaxialpaares und dem Schirm c eine Störspannung auftritt, so treibt diese einen Strom über die hochspannungsfesten Trennkondensatoren. Bei den bei breitbandigen Übertragungssystemen geforderten hohen Bandbreiten von beispielsweise mehreren 100 MHz und einer Spannungsfestigkeit von beispielsweise 5 kV weisen diese Koppelkondensatoren nicht unbeträchtliche geometrische Abmessungen auf. Sie zeigen daher im betrachteten sehr breiten Frequenzbereich kein rein kapazitives Verhalten mehr, stellen also keinen hochfrequenzmäßigen Kurzschluß mehr dar. Ein Störstrom durch diese Koppelkondensatoren bewirkt daher eine Störspannung, welche sich in ungünstiger Weise auf das Verhalten des Verstärkers oder Regenerators auswirkt. Insbesondere bei Frequenzen, bei denen der entzerrende Verstärker im Leitungsendgerät eine hohe Verstärkung aufweist, kann einem empfangenen Nutzsignal eine beträchtliche Störung überlagert werden, welche bei einem Digitalsystem zu Bitfehlern im empfangenen Digitaldatenstrom führt.

Die Entstehung einer Störspannung wäre dann nicht möglich, wenn die gesamte Aufteilungsmuffe am Ende eines Koaxialfernkabels sowie die Verbindung zum Leitungsendgerät und dieses selbst lückenlos geschirmt wäre, da eine Störung dann nicht eindringen könnte. Eine derart vollkommene Schirmung ist aber nicht möglich, da aus der Aufteilungsmuffe am Ende des Fernkabels nicht nur die einzelnen Koaxialpaare triaxial, d.h. Innenleiter « a », Außenleiter « b » und Schirm « c », herausgeführt sind, sondern auch die ungeschirmten symmetrischen Leitungen des Beipacks durch einen druckgasdichten, elektrisch nicht leitenden oder mindestens gegen den Beipack isolierten Deckel. Gelangt eine Störspannung gegen Masse auf die Leitungen des Beipacks, so kommt mindestens ein Teil dieser Störung auch im Kabel durch kapazitive Verkopplung auf jeden Außenleiter b der Koaxialpaare und erzeugt eine Störspannung zwischen b und c. Diese Störspannung kann, wie bereits erwähnt, einen Störstrom über die hochspannungsfesten Koppelkondensatoren treiben und somit eine Störung im Übertragungsverhalten des empfangsseitigen Leitungsendgerätes bewirken.

Der Erfindung liegt die Aufgabe zugrunde, den Einfluß der beschriebenen Störungen auf das empfangsseitige Leitungsendgerät möglichst vollkommen zu beseitigen.

Diese Aufgabe wird bei einer Eingangsanordnung der einleitend geschilderten Art erfindungsgemäß dadurch gelöst, daß eine Koaxialleitung, umgeben von einem elektrisch leitenden Gehäuse, vorgesehen ist, das eingangsseitig mit dem Schirm der triaxialen Leitung und ausgangsseitig mit dem Gehäuse des Leitungsendgerätes verbunden ist, daß die Koaxialleitung und das Gehäuse der Eingangsanordnung zu wenigstens einem Filterglied ausgebaut sind und daß als Filterglied wenigstens ein auf die Koaxialleitung aufgeschobener Ferritring und wenigstens ein zwischen dem Außenleiter der Koaxialleitung und dem Gehäuse angeordneter Querkondensator vorgesehen ist.

Aus der DE-A-19 11 960 und aus der Zeitschrift « Frequenz » 28, (1974), 12, S. 326-333, Bild 2c1 sind zwar bereits Filterglieder mit Ferritringen bekannt, jedoch sind diese, Filterglieder in den Ein- und Ausgangsweichen von Verstärkern mit Gleichstrom-Reihenfernspeisung eingesetzt und dienen dort einer anderen Aufgabe, nämlich der Erhöhung der Umlaufdämpfung des Verstärkers. Auch wird der Außenleiter des Koaxialkabels weitergeführt und umgeht das Filterglied. Bei alleinigem Einsatz einer derartigen Leitungsdrossel kann eine Störung der eingangs geschilderten Art nicht beseitigt werden.

Für die praktische Ausführung des Erfindungsgegenstandes ist es von Vorteil, wenn der Querkondensator aus mehreren Parallelkondensatoren gebildet ist, die konzentrisch um die Koaxialleitung angeordnet sind.

Das Filterglied kann in vorteilhafter Weise als triaxiales Filter aufgebaut sein. Der prinzipielle Aufbau eines koaxial aufgebauten Filters ist aus der oben genannten Literaturstelle, Bild 15e, f bekannt. Diese Struktur läßt sich auf ein triaxiales Filter erweitern.

Die erfindungsgemäße Eingangsanordnung kann sowohl vor dem empfangsseitigen Leitungsendgerät als auch in diesem angeordnet sein.

Anhand von Ausführungsbeispielen wird die Erfindung nachstehend näher erläutert.

Fig. 1 zeigt ein Beispiel für ein empfangsseitiges Leitungsendgerät für ein hochratiges PCM-Übertragungssystem,

Fig. 2 zeigt einen Schnitt durch die Aufteilungsmuffe am Ende eines Koaxial-Fernkabels,

Fig. 3 zeigt ein praktisch ausgeführtes erfindungsgemäßes Filter und

Fig. 4 zeigt das Ersatzbild für ein Filterglied nach der Erfindung.

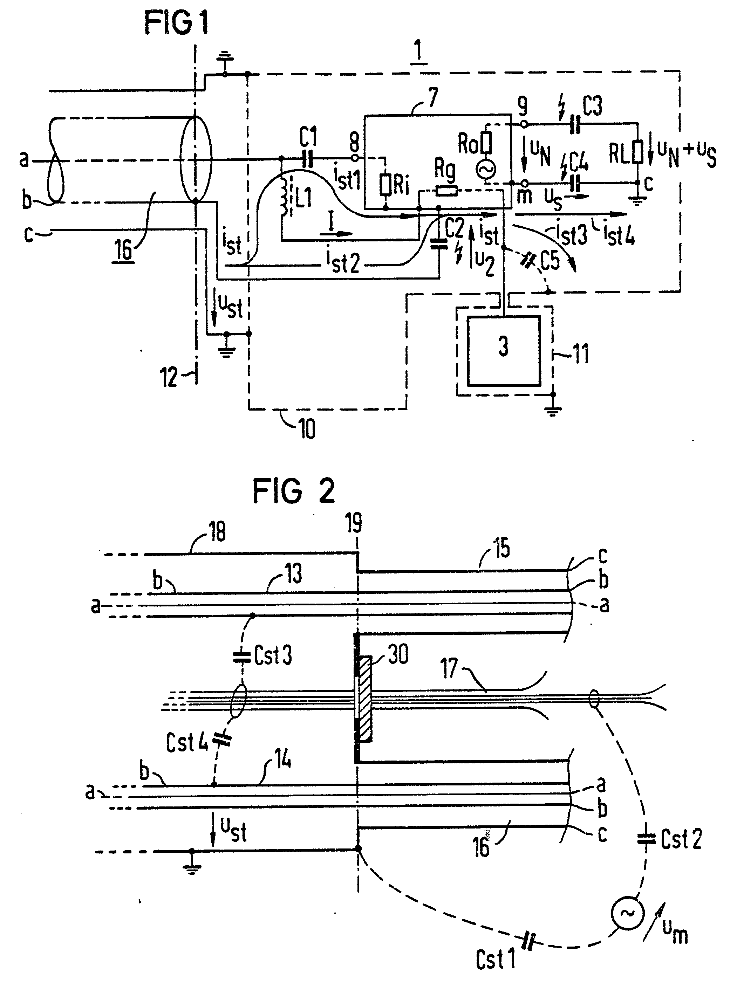

Fig. 1 zeigt ein bekanntes empfangsseitiges Leitungsendgerät 1, das über die triaxiale Schnittstelle 12 und über eine triaxiale Leitung 16 mit einem Koaxialpaar a, b und dessen Schirm c eines Fernkabels verbunden ist, sowie ein Fernspeisegerät 3.

Die triaxiale Leitung 16 enthält ebenfalls einen Innenleiter a und einen Außenleiter b, die zusammen ein Koaxialpaar bilden, sowie einen Schirm c.

Das Leitungsendgerät 1 enthält einen Eingangsregenerator 7 mit einem Eingang 8 und einem Ausgang 9 sowie eine Drossel L1, Kondensatoren C1 und C2 und einen Widerstand RL.

Der Eingangsregenerator 7 enthält einen entzerrenden Verstärker und nichtlineare Schaltungsteile zur Regenerierung des entzerrten Digitalsignals.

Der Innenleiter a des im Triaxialkabel 16 enthaltenen Koaxialpaares a, b ist über den Trennkondensator C1 mit dem Eingang 8 des im Eingangsregenerator 7 enthaltenen entzerrenden Verstärkers verbunden. Über den Innenleiter a, die Drossel L1 und den Eingangsregenerator 7 fließt der Fernspeisestrom zum Fernspeisegerät 3. Der Eingangsregenerator 7 bezieht seine Leistung im dargestellten Beispiel ebenfalls von der Fernspeisung. Dies wird durch den Verbraucher Rg des Eingangsregenerators 7 symbolisiert. Sowohl dieses Fernspeisegerät 3 als auch das empfangsseitige Leitungsendgerät 1 befinden sich in Gehäusen 10, 11, welche mit Masse, also dem Schirm c, verbunden sind. Die Verbindung zwischen diesen Geräten ist ebenfalls geschirmt, der Schirm ist mit Masse verbunden. Der Ausgang 9 des Eingangsregenerators 7 ist über hochspannungsfeste Kondensatoren C3 und C4 mit einem Verbraucherwiderstand RL verbunden, welcher einseitig am Schirm c und damit an Masse liegt. Der Verbraucherwiderstand RL symbolisiert eine Leitung aus dem Leitungsendgerät 1 zu anderen Geräten (Demultiplexer). Diese Verbindung ist in Fig. 1, da für den Erfindungsgegenstand unerheblich, nicht dargestellt. In der Praxis sind neben den Kondensatoren C3, C4 noch weitere Verbindungen zwischen dem auf der Bezugspotentialebene m des Eingangsregenerators 7 liegenden Schaltungsteil und dem auf dem Potential des Schirmes c der jamit dem Gehäuse 10, 11 verbunden ist, liegenden Schaltungsteil notwendig, etwa für die Übertragung des wiedergewonnenen Taktes. Auch diese Verbindungen und die notwendigen Schaltungsteile sind in Fig. 1 nicht eingezeichnet. Es sei zur näheren Erläuterung auf den älteren Vorschlag DE-A1-28 04 086 verwiesen.

In dem in Fig. 1 als Beispiel dargestellten empfangsseitigen Leitungsendgerät für ein hochratiges PCM-System wird das ankommende Digitalsignal, welches zwischen Innenleiter a und Außenleiter b des Koaxialpaares a, b liegt, dem Eingang 8 des Eingangsregenerators 7 über die Kondensatoren C1 und C2 zugeführt. Die Eingangsimpedanz des Regenerators ist durch den Widerstand Ri symbolisiert. Des Kondensator C2 ist ein Hochspannungskondensator, da zwischen b und a eine beträchtliche Spannungsdifferenz von beispielsweise 1200 V, im Blitzfall aber bis zu mehreren kV auftreten kann. Der Speisegleichstrom wird über die Drossel L1, welche bei einem Breitband-PCM-System auch durch eine kurzgeschlossene Leitung ersetzt sein kann, wie es in dem älteren Vorschlag beschrieben ist, vom Digitalsignal getrennt. Das Spektrum des Digi-

...alsignals ist zu diesem Zweck so geformt, daß es bei der Frequenz Null eine Nullstelle aufweist.

Das Ausgangssignal des Eingangsregenerators 7 wird ebenfalls geeignet spektral vorgeformt, so daß es über die Kondensatoren C3 und C4 dem an Masse, also am Schirm c liegenden Verbraucher RL zugeführt werden kann.

Wenn zwischen dem Außenleiter b des Koaxialpaares a, b und dem Schirm c eine Störspannung $u_{st}$ auftritt, wie dies in Fig. 1 eingezeichnet ist, so treibt diese einen Strom $i_{st}$ in das empfangsseitige Leitungsendgerät. Am Eingang des Leitungsendgerätes verzweigt sich dieser Strom in zwei Teilströme, nämlich einmal in den Strom $i_{st1}$, welcher über den Kondensator C1 in den Eingang 8 mit dem Eingangswirderstand Ri des Eingangsregenerators 7 fließt, und den Strom $i_{st2}$, welcher über den Kondensator C2 fließt. Beide Ströme vereinigen sich in der Bezugspotentialebene m des Eingangsregenerators 7 wieder zum Störstrom $i_{st}$. Der Stromkreis schließt sich über die verschiedenen Kapazitäten gegen Masse. So fließt ein Hauptteil des Störstromes, welcher mit $i_{st4}$ bezeichnet ist über die Kapazität C4 gegen Masse. Ein weiterer Teil des Störstromes wird über die Kapazität C5 zwischen dem Schirm c und dem Fernspeisegerät 3 bzw. dessen Zuleitung gegen Masse abfließen. Dieser Anteil wird mit $i_{st3}$ bezeichnet. Da die Ankopplung von RL unsymmetrisch ist, hauptsächlich wegen der Quellimpedanz Ro am Ausgang des Eingangsregenerators 7, erzeugt $i_{st4}$ eine Störspannung $u_s$, welche sich zur Nutzspannung $u_N$ in Reihe legt und an RL erscheint. Außerdem entsteht auch am Kondensator C2 eine Störspannung $u_2$, denn ein 5 kV-Kondensator mit der hier erforderlichen Kapazität von einigen nF und den hieraus resultierenden nicht unbeträchtlichen geometrischen Abmessungen weist im hier betrachteten sehr breiten Frequenzbereich von beispielsweise 600 MHz kein rein kapazitives Verhalten auf, stellt also keinen hochfrequenzmäßigen Kurzschluß dar. Deshalb tritt die bereits beschriebene Stromteilung auf. Die Störspannung $U_2$ am Kondensator C2 treibt über die Eingangsimpedanz des Koaxialpaares a, b, welche 75 Ω beträgt, und den Kondensator C1 einen Störstrom $i_{st1}$ in den Eingang 8 des im Eingangsregenerator 7 enthaltenen entzerrenden Verstärkers. Insbesondere bei Frequenzen, bei denen dieser Verstärker eine hohe Verstärkung aufweist, kann so durch die Störspannung $U_{st}$ dem empfangenen Nutzsignal eine beträchtliche Störung überlagert werden, welche zu Bitfehlern im empfangenen Digitaldatenstrom führt.

Könnten die Kondensatoren C1, C2 durch einen hinreichend symmetrischen, hochspannungsfesten und breitbandigen Übertrager ersetzt werden, so würde die Störung zwar reduziert, sie verschwindet aber wegen der Streukapazität zwischen den Übertragerwicklungen auch nicht völlig. Außerdem besteht immer noch der parasitäre Weg für den Störstrom über die unvermeidliche Kapazität C5 zwischen dem Fernspeisegerät 3, dessen Zuleitung zum Leitungsendgerät und dessen Gehäuse 11, das mit dem Schirm c verbunden ist. Diese Zuleitung könnte zwar verdrosselt werden, der Störstrom läßt sich aber infolge weiterer in der Praxis auftretender parasitärer Kapazitäten nicht völlig reduzieren. Auch der Einsatz eines Übertragers am Eingang des empfangsseitigen Leitungsendgerätes 1 könnte diesen Effekt nicht völlig vermeiden, da stets eine hochspannungsfeste Trennung zwischen Innen- und Außenleiter des Koaxialpaares notwendig ist, also wiederum der Einsatz eines Hochspannungskondensators, sowie die Zuführung des Fernspeisestromes zum Innenleiter a des Koaxialpaares a, b. Das Auftreten eines Störstromes $i_{st}$ kann also in keinem Falle völlig vermieden werden.

Die Entstehung einer Störspannung $U_{st}$ wäre dann nicht möglich, wenn die gesamte Anordnung ideal geschirmt wäre, da eine Störung dann in das System gar nicht eindringen kann. Leider ist eine derart vollkommene Schirmung nicht möglich. Zur Erläuterung des Auftretens der Störung zeigt Fig. 2 einen schematischen Querschnitt durch die Aufteilungsmuffe am Ende eines Koaxialfernkabels. Das Ende des Koaxialfernkabels in der oberirdischen Endstelle wird durch die sogenannte Aufteilungsmuffe 19 gebildet. Aus dieser Aufteilungsmuffe werden die einzelnen Koaxialpaare in Form triaxialer Leitungen herausgeführt. Beispielhaft sind zwei Koaxialpaare 13, 14 dargestellt, welche über triaxiale Leitungen 15, 16 zum Verbraucher geführt werden. Ferner sind symmetrische Leitungen 17, der sogenannte Beipack, im Fernkabel enthalten. Diese werden durch einen druckgasdichten, aber nicht leitenden oder mindestens gegen den Beipack isolierten Verschlußdeckel 30 geführt. Die Außenleiter der Koaxialpaare 13, 14 sind wiederum mit b, die Innenleiter mit a bezeichnet, der gemeinsame Kabelaußenleiter, welcher geerdet ist, ist mit 18 bezeichnet. Wie Fig. 2 zeigt, ist eine vollkommene Schirmung des Kabels nicht möglich, da aus der Aufteilungsmuffe 19 die ungeschirmten symmetrischen Leitungen des Beipacks herausgeführt werden müssen. Gelangt über die Streukapazitäten $C_{st1}$ und $C_{st2}$ in Form einer elektromagnetischen Welle oder durch unsymmetrischen Betrieb der symmetrischen Leitungen eine Spannung gegen Masse auf die Leitungen des Beipacks 17, so gelangt mindestens ein Teil dieser Störung im Kabel auch über die Kapazitäten $C_{st3}$, $C_{st4}$ zwischen dem Beipack 17 und den Außenleitern b der Koaxialpaare auf jeden Außenleiter b und erzeugt somit die Störspannung $u_{st}$ zwischen b und c. Das Auftreten solcher Störungen in der oberirdischen Endstelle ist nie ganz zu vermeiden. Es treten beispielsweise Schaltknacke beim Ein- und Ausschalten von Geräten, Beleuchtungen, Lötkolben, Maschinen und dgl. auf. Da derartige Schaltstörungen ein außerordentlich breites Frequenzspektrum aufweisen, welches bis ca. 1 GHz reichen kann, führen sie zu erheblichen breitbandigen Störungen, die sich, wie bereits beschrieben, dem Eingangssignal des Eingungsregenerators 7 überlagern und zu Bitfehlern führen können.

Aus der eingangs genannten Zeitschrift « Frequenz », Band 28, Dez. 1974, Seiten 326-333 ist es bereits bekannt, sogenannte Leitungsdrosseln als Bestandteil von Ein- und Ausgangsweichen in ferngespeisten Trägerfrequenzzwischenverstärkern zu verwenden. Der Einsatz einer derartigen Leitungsdrossel am Eingang des empfangsseitigen Leitungsendgerätes kann ebenfalls dazu dienen, die Störung zu vermindern, da diese Leitungsdrossel für den Störstrom $i_{st}$ eine hochohmige Impedanz darstellt. Es kann auch stattdessen die Zuleitung zum Verbraucher RL, die bei den notwendigen großen Bandbreiten im allgemeinen koaxial ausführt ist, durch Aufschieben von Ferritringen als Leitungsdrossel ausgeführt werden. Während das Nutzsignal in den beiden « Wicklungen » entgegengesetzt gerichtete Magnetfelder erzeugt, die sich aufheben, und somit von den gegensinnigen Ferritkernen unbeeinflußt bleibt, wirkt eine derartige Anordnung für den Störstrom $i_{st}$ als breitbandige Drossel. In der genannten Druckschrift wird die Leitungsdrossel durch eine Verbindung der Außenleiter b der beiden Koaxialpaare am Ein- und Ausgang der Zwischenverstärker umgangen. Eine derartige Verbindung ist bei Einsatz einer Leitungsdrossel in einem Leitungsendgerät nicht zulässig. Der Einsatz eines Übertragers an der hochspannungsfesten Schnittstelle würde, wie bereits erwähnt die Störung zwar reduzieren. Ein derartiger hochspannungsfester und breitbandiger Übertrager ist aber nicht ohne weiteres verfügbar und ist teuerer als die Lösung mit Kondensatoren. Auch könnte wegen der zusätzlichen parasitären Kapazitäten, wie bereits erwähnt, das Auftreten eines Störstromes auch durch diese Maßnahme nicht völlig vermieden werden.

Wird eine Leitungsdrossel in die Zuleitung zu RL eingeführt, so kann eine Verbesserung der Störunterdrückung durch Ergänzung der Drossel zu einem LC-Filter mittels Kapazitäten zwischen dem Außenleiter dieser Koaxialleitung und Masse nicht erzielt werden, da diese Kapazität nur die Drossel teilweise kurzschließen und somit $i_{st}$ nicht nur nicht schwächen, sondern sogar vergrößern würde. Am Innenleiter wäre eine derartige Maßnahme sowieso unzulässig, da das Nutzsignal kurzgeschlossen würde.

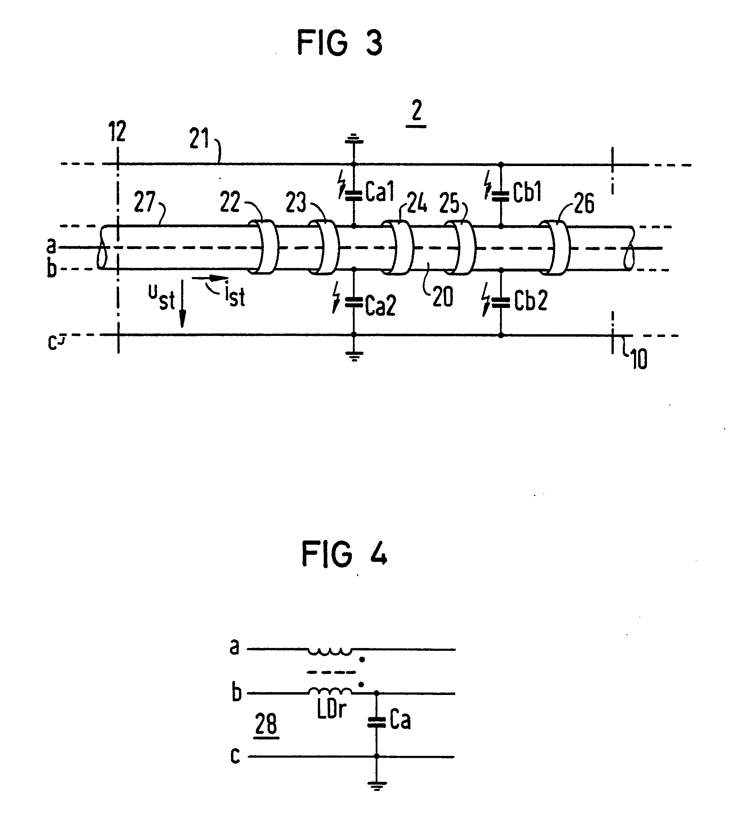

Die erfindungsgemäße Maßnahme sieht daher vor, die Störung gar nicht erst in den auf dem Potential des Innenleiters a 'liegenden Schaltungsteil eindringen zu lassen. Als erfindungsgemäße Maßnahme wird die Einfügung eines leitungsartigen, verteilten LC-Filters aus Leitungsdrosseln und Querkapazitäten am Eingang des empfangsseitigen Leitungsendgerätes vorgesehen. Fig. 3 zeigt einen schematischen Schnitt durch ein Ausführungsbeispiel eines Filters nach der Erfindung am Eingang des empfangsseitigen Leitungsendgerätes 1. Es ist ein die Koaxialleitung 20 umgebendes elektrisch leitendes Gehäuse 21 vorgesehen, das eingangsseitig über die triaxiale Schnittstelle 12 mit dem Schirm c und ausgangsseitig mit dem Gehäuse 10 des Leitungsendgerätes 1 verbunden ist. Die Koaxialleitung ist durch Aufschieben von Ferritringen 22 bis 26 zu Leitungsdrosseln ergänzt worden. In Abständen sind zwischen den Ferritringen 22 bis 26 Querkondensatoren Ca1, Ca2, Cb1, Cb2 zwischen dem Außenleiter 27 der Koaxialleitung 20 und dem Gehäuse 21 angebracht. Ein durch die Störspannung $u_{st}$ zwischen dem Außenleiter 27 der Koaxialleitung 20 und dem Gehäuse 21 bewirkter Störstrom $i_{st}$ kann hierdurch auf einen vernachlässigbar kleinen Wert reduziert werden.

Fig. 4 zeigt zur Verdeutlichung der Funktion das elektrische Ersatzbild eines Filtergliedes 28, welches aus einer Leitungsdrossel LDr und einem Querkondensator Ca zwischen den Potentialen b und c gebildet ist. Der Signalfluß zwischen dem Innenleiter a und dem Außenleiter b wird, wie bereits erläutert, nicht beeinflußt.

Wie in Fig. 3 bereits schematisch dargestellt ist, kann jeder Querkondensator Ca aus mehreren parallelen Querkondensatoren Ca1, Ca2 gebildet sein, welche konzentrisch um die Koaxialleitung 20 angeordnet sind. Hierdurch kann das Hochfrequenzverhalten der resultierenden Gesamtkapazität des Querkondensators Ca entscheidend verbessert werden, da die Gesamtkapazität vergrößert wird, ohne daß die geometrischen Abmessungen der Einzelkapazitäten vergrößert werden müssen.

Über die Form des Gehäuses 21 wurden zunächst keine Angaben gemacht. Bei einer konzentrischen Anordnung erweist sich aber eine Ausgestaltung des beschriebenen Filtergliedes als triaxiales Filter als besonders zweckmäßig. Eine besonders breitbandige Realisierung läßt sich in Anlehnung an eine in der Literaturstelle « Frequenz » vom Dez. 1974, S. 326 bis 33, Bild 15e, beschriebenen leitungsähnliche koaxiale Anordnung dann erzielen, wenn abwechselnd auf die Koaxialleitung 20 aufgestecke zylinderförmige Hochspannungskondensatoren und Ferritringe in einer triaxialen Anordnung vereinigt werden.

Eine andere Möglichkeit zur Realisierung ist ein beidseitig mit Triaxialsteckern versehenes Rohr von hinreichend großem Durchmesser, in welchen keramische Hochspannungchipkondensatoren zur Verbindung des Außenleiters 27 der Koaxialleitung 20 und des Gehäuses 21 dienen.

Es ist auch eine konstruktive Vereinigung dieser in der beschriebenen Eingangsanordnung mit der Eingangsweiche des empfangsseitigen Leitungsendgerätes möglich. Die erfindungsgemäße Anordnung ist dann mit in das Leitungsendgerät eingebaut.

Die beschriebene Anordnung verhindert sehr zuverlässig die Auswirkung aller Störungen zwischen b und c auf das empfangsseitige Leitungsendgerät. Der Signalfluß im Koaxialpaar a, b wird von einem derartigen Filter nicht beeinflußt. Die Anordnung liegt in Serie zum triaxialen Anschlußkabel, welches Leitungsendgerät und Aufteilungsmuffe 19 verbindet. Zweckmäßig wird die Eingangsanordnung dicht beim Leitungsendgerät angebracht, oder in dieses mit integriert, so daß Störeinkopplungen in das Triaxialkabel, etwa durch mangelhaften Schirm c, mit reduziert werden. Selbstverständlich wäre auch eine derartige. Maßnahme am Ausgang des sendeseitigen Leitungsendgerätes denkbar, falls erforderlich. Da an der hochspannungsfesten Trennstelle im sendeseitigen Leitungsendgerät der Signalstörabstand im allgemeinen sehr groß ist, wird sich diese Maßnahme aber in der Regel erübrigen.

Es soll nochmals betont werden, daß die beschriebene erfindungsgemäße Anordnung das Eindringen von Störungen in das empfangsseitige Leitungendgerät bei beliebigen Übertragungssystemen mit Schwebepotential und Gleichstrom-Reihenspeisung zuverlässig verhindert, unabhängig von der Struktur der im Leitungsendgerät enthaltenen Fernspeiseweichen und unabhängig davon, ob in diesem System analoge oder digitale Signale übertragen werden.

### Ansprüche

1. Eingangsanordnung (2) für ein empfangsseitiges Leitungsendgerät (1) eines Nachrichtenübertragungssystems mit Gleichstrom-Fernspeisung über die Innenleiter (a) von Koaxialpaaren (a, b), die zusammen mit symmetrischen Leitungen (17) in einem Kabel mit gemeinsamem Kabelaußenleiter (18) zusammengefaßt sind, mit einer Eingangsweiche (L1, C1) im Leitungsendgerät (1), das über eine triaxiale Schnittstelle (12) an eine triaxiale Leitung (16), die aus einem der Koaxialpaare (a, b) und einem mit dem Kabelaußenleiter (18) verbundenen Schirm (c) besteht, angeschaltet ist, dadurch gekennzeichnet, daß eine Koaxialleitung (20), umgeben von einem elektrisch leitenden Gehäuse (21), vorgesehen ist, das eingangsseitig mit dem Schirm (c) der triaxialen Leitung (16) und ausgangsseitig mit dem Gehäuse (10) des Leitungsendgerätes (1) verbunden ist, daß die Koaxialleitung (20) und das Gehäuse (21) der Eingangsanordnung (2) zu wenigstens einem Filterglied (28) ausgebaut sind und daß als Filterglied (28) wenigstens ein auf die Koaxialleitung (20) aufgeschobener Ferritring (22) und wenigstens ein zwischen dem Außenleiter (27) der Koaxialleitung (20) und dem Gehäuse (21) angeordneter Querkondensator (Ca) vorgesehen ist.

2. Eingangsanordnung nach Anspruch 1, dadurch gekennzeichnet, daß der Querkondensator (Ca) aus mehreren parallelen Querkondensatoren (Ca1, Ca2) gebildet ist, die konzentrisch um die Koaxialleitung (20) angeordnet sind.

3. Eingangsanordnung nach Anspruch 1, dadurch gekennzeichnet, daß das Filterglied (28) als triaxiales Filter aufgebaut ist.

4. Eingangsanordnung nach einem der vorhergehenden Ansprüche, dadurch gekennzeichnet, daß sie im empfangsseitigen Leitungsendgerät (1) angeordnet ist.

### Claims

1. An input arrangement (2) for a line terminal device (1) connected at the receiving end of a communications transmission system, with direct current remote feeding via the inner conductors (a) of coaxial lines (a, b) which are combined together with symmetrical lines (17) in a cable with a common cable outer conductor (18), comprising an input switch (L1, C1) in the line terminal device (1), which is connected via a triaxial intersection point (12) to a triaxial line (16) which consists of one of the coaxial pairs (a, b) and a screen (c) which is coupled to the cable outer conductor (18), characterised in that a coaxial line (20) is surrounded by an electrically conductive housing (21) connected to the screen (c) of the triaxial line (16) at the input end and to the housing (10) of the line terminal device (1) at the output end, that the coaxial line (20) and the housing (21) of the input arrangement (2) are designed to form at least one filter element (28) comprising at least one ferrite ring (22) is slipped onto the coaxial line (20) and at least one shunt capacitor (Ca) is arranged between the outer conductor (27) of the coaxial line (20) and the housing (21).

2. An input arrangement as claimed in claim 1, characterised in that the shunt capacitor (Ca) is composed of a plurality of parallel shunt capacitors (Ca1, Ca2) concentrically arranged around the coaxial line (20).

3. An input arrangement as claimed in claim 1, characterised in that the filter element (28) is a triaxial filter.

4. An input arrangement as claimed in one of the preceding claims, characterised in that the input arrangement is in the line terminal device (1) at the receiving end.

### Revendications

1. Dispositif d'entrée (2, pour un appareil terminal de ligne, situé du côté réception, pour un système de transmission d'informations à alimentation à distance en courant continu par l'intermédiaire de conducteurs intérieurs (a) de paires coaxiales (a, b) qui sont assemblés avec des lignes symétriques (17) en un câble à conducteur extérieur de commande (18), du type comportant un aiguillage d'entrée (L1, C1) dans l'appareil terminal de ligne qui est relié, par l'intermédiaire d'un point de jonction triaxial (12), à une ligne triaxiale (16) qui est constituée par l'une des paires coaxiales (a, b) et par un blindage (c) relié aux conducteurs (18) du câble, caractérisé par le fait qu'il est prévu une ligne coaxiale (20) entourée d'un boîtier (21) électriquement conducteur et relié, du côté entrée, au blindage (c) de la ligne triaxiale (16), et, du côté sortie, au boîtier (10) dudit appareil terminal de ligne, que la ligne coaxiale (20) et le boîtier (21) du dispositif d'entrée (2) sont complétés en au moins un filtre (28), et qu'il est prévu, comme filtre (28), au moins une bague de ferrite (22) engagée sur la ligne coaxiale (20) et un condensateur transversal (Ca) monté entre le conducteur extérieur (27) de la ligne coaxiale (20) et le boîtier (21).

2. Dispositif selon la revendication 1, caractérisé par le fait que le condensateur transversal (Ca) est constitué par plusieurs condensateurs transversaux (Ca1, Ca2) montés en parallèle et disposés concentriquement autour de la ligne coaxiale (20).

3. Dispositif selon la revendication 1, caractérisé par le fait que le filtre (28) est constitué sous la forme d'un filtre triaxial.

4. Dispositif selon l'une des revendications précédentes, caractérisé par le fait qu'il est disposé dans l'appareil terminal de ligne (1) situé du côté réception.

FIG 1

FIG 2

# FIG 3

# FIG 4